# EUROPEAN PATENT APPLICATION

(11) **EP 4 131 351 A1**
(43) Date of publication of application: **08.02.2023**
(21) Application number: 21855274.3
(22) Date of filing: 30.06.2021
(51) Int. Cl.: H01L 21/66, G03F 7/20, G03F 9/00

(54) **SEMICONDUCTOR STRUCTURE**

(30) Priority: 12.08.2020 CN 202010804638
(71) Applicant: Changxin Memory Technologies, Inc., Hefei, Anhui 230601 (CN)
(72) Inventor: XIA, Yunsheng, Hefei Anhui 230601 (CN)
(74) Representative: V.O.
(86) International application number: PCT/CN2021/103522
(87) International publication number: WO 2022/033221

(57) **Abstract**

A semiconductor structure is provided, including several first patterns located in a photoresist layer with a thickness greater than 1.2 um and arranged in a first direction, and several second patterns arranged in a second direction. The first direction and the second direction have an included angle. The first patterns have a first arrangement length in the first direction. The second patterns have a second arrangement length in the second direction. An area sum of the first patterns and the second patterns is less than 1/2 of a product of the first arrangement length and the second arrangement length.

## Description

### CROSS-REFERENCE TO RELATED APPLICATION

The present application claims priority to China Patent Application No. 202010804638.6, filed on August 12, 2020 in China National Intellectual Property Administration and entitled "SEMICONDUCTOR STRUCTURE", which is hereby incorporated by reference in its entirety.

### TECHNICAL FIELD

The embodiments of the present disclosure relate to the technical field of semiconductors, and in particular to a semiconductor structure.

### BACKGROUND

With the rapid development of the semiconductor technology, the size of a semiconductor device is getting smaller and smaller, and higher requirements are put forward for accuracy of the alignment measurement of different layers in a manufacturing process.

However, ion implantation of some layers in fabrication of the semiconductor device is relatively deep. High-energy exposure is needed during exposure, which can easily lead to deformation or foldover of a marking graph, so that a poor appearance is generated in the marking graph. This seriously affects the accuracy of measurement, resulting in a reduction in the yield of the semiconductor device.

### SUMMARY

According to some embodiments, the present disclosure provides a semiconductor structure, including:

several first patterns arranged in a first direction and located in a photoresist layer with a thickness greater than 1.2 um, and several second patterns arranged in a second direction. The first direction and the second direction have an included angle.

The first patterns have a first arrangement length in the first direction. The second patterns have a second arrangement length in the second direction. An area sum of the first patterns and the second patterns is less than 1/2 of a product of the first arrangement length and the second arrangement length.

### BRIEF DESCRIPTION OF THE DRAWINGS

In order to describe the technical solutions in the embodiments of the present disclosure or in the existing art more clearly, drawings required to be used in the embodiments or the illustration of the traditional technology will be briefly introduced below. Apparently, the drawings in the illustration below are only some embodiments of the present disclosure. Those ordinarily skilled in the art also can acquire other drawings according to the provided drawings without doing creative work.
FIG. 1 is a schematic top view of a semiconductor structure provided in a first embodiment;
FIG. 2 is a schematic top view of a semiconductor structure provided in a second embodiment;
FIG. 3 is a schematic top view of a semiconductor structure provided in a third embodiment;
FIG. 4 is a schematic top view of a semiconductor structure provided in a fourth embodiment;
FIG. 5 is a schematic top view of a semiconductor structure provided in a fifth embodiment;
FIG. 6 is a schematic top view of a semiconductor structure provided in a sixth embodiment;
FIG. 7A is a Qmerit measurement result of a traditional marking graph;
FIG. 7B is a Qmerit measurement result of a marking graph provided in the second embodiment; and
FIG. 7C is a Qmerit measurement result of a marking graph provided in the fourth embodiment.

### DETAILED DESCRIPTION

For convenience of an understanding of the present disclosure, the embodiments of the present disclosure will be described more fully below with reference to the related accompanying drawings. Some embodiments of the present disclosure are provided in the drawings. The present disclosure may, however, be embodied in many different forms which are not limited to the embodiments described herein. Rather, these embodiments are provided so that the disclosed content of the present disclosure will be more thorough and complete.

Unless defined otherwise, all technical and scientific terms used herein have the same meaning as commonly understood by those skilled in the art to which the present disclosure belongs. The terms used in the specification of the embodiments of the present disclosure are used only for the purpose of describing the specific embodiments and are not intended to restrict the embodiments of the present disclosure. In addition, certain terms used throughout the specification and the following claims refer to specific elements. Those skilled in the art will understand that manufacturers can refer to components with different names. This document does not intend to distinguish elements with different names but same functions. In the following description and embodiments, the terms "including" and "include" are used openly, and therefore should be interpreted as "including, but not limited to...". In the same way, the term "connect" is intended to express an indirect or direct electrical connection. Correspondingly, if one equipment is connected to another equipment, the connection can be done through a direct electrical connection, or through an indirect electrical connection between other equipment and a connection piece.

It should be understood that although the terms "first", "second", etc. may be used herein to describe various elements, these elements should not be limited by these terms. These terms are only used to distinguish one element from another element. For example, without departing from the scope of the present disclosure, the first element may be referred to as the second element, and similarly, the second element may be referred to as the first element.

The term "several" in the embodiments of the present disclosure refers to one or more.

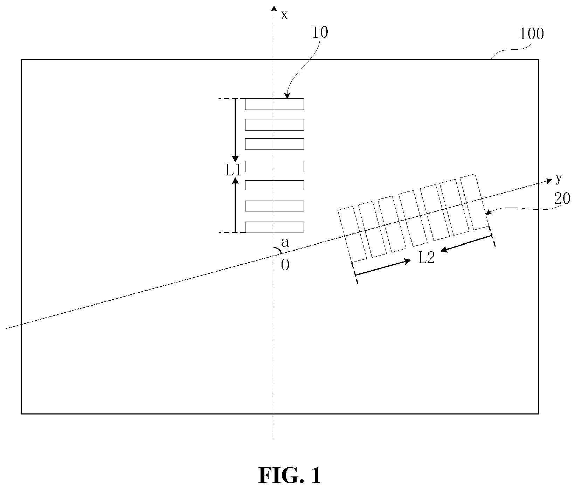

Referring to FIG. 1, a semiconductor structure provided in one embodiment of the present disclosure includes several first patterns 10 arranged in a first direction Ox and located in a photoresist layer 100 with a thickness greater than 1.2 um and several second patterns 20 arranged in a second direction Oy. The first direction Ox and the second direction Oy have an included angle a, 0 degrees<a<180 degrees. The first patterns 10 have a first arrangement length L1 in the first direction Ox, and the second patterns 20 have a second arrangement length L2 in the second direction Oy. A total area of the first patterns 10 is S1, and a total area of the second patterns 20 is S2, S1+S2<0.5L1^{∗}L2.

For example, continuing to refer to FIG. 1, by arranging the several first patterns 10 in the first direction Ox on the photoresist layer 100 with the thickness greater than 1.2 um and the several second patterns 20 in the second direction Oy, the first direction Ox and the second direction Oy have the included angle a, 0 degree<a<180 degrees. The first patterns 10 have the first arrangement length L1 in the first direction Ox, and the second patterns 20 have the second arrangement length L2 in the second direction Oy, so that it can facilitate accurate measurement of different layers in the semiconductor structure through the first patterns 10 and the second patterns 20. The first patterns 10 and the second patterns 20 are formed on the photoresist layer 100 with the thickness greater than 1.2 um, and photoresist provides good support for the first patterns 10 and the second patterns 20, so that the phenomenon of reduction in the measurement efficiency and the accuracy caused by deformation or foldover of partial marking graphs during high-energy exposure is avoided. An area sum of the first patterns 10 and the second patterns 20 is less than 1/2 of a product of the first arrangement length L1 and the second arrangement length L2, thus facilitating disposing the plurality of first patterns and the plurality of second patterns to further improve the measurement accuracy and increase the yield of a fabricated semiconductor device.

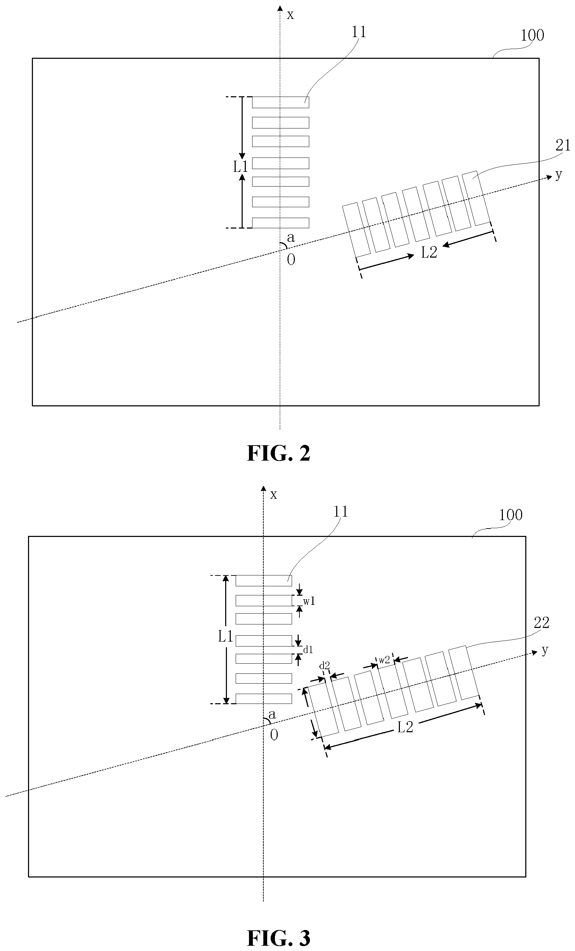

Referring to FIG. 2, in one embodiment of the present disclosure, the first patterns and the second patterns are both patterns with gaps. The first patterns are provided as first rectangular through holes 11. A plurality of first rectangular through holes 11 are arranged at intervals in the first direction Ox, and have a first arrangement length L1 in the first direction Ox. The second patterns are provided as second rectangular through holes 21. A plurality of second rectangular through holes 21 are arranged at intervals in the second direction Oy, and have a second arrangement length L2 in the second direction Oy. The area sum of orthographic projections of the various first rectangular through holes 11 on a surface of the photoresist layer 100 and orthographic projections of the various second rectangular through holes 21 on the surface of the photoresist layer 100 is less than 1/2 of the product of the first arrangement length L1 and the second arrangement length L2. The plurality of first rectangular through holes 11 and the plurality of second rectangular through holes 21 are used as the marking graphs to realize accurate measurement via the marking graphs. The photoresist layer 100 provides good support for the marking graphs, so that the phenomenon of reduction in the measurement efficiency and the accuracy caused by deformation or foldover of partial marking graphs during high-energy exposure is avoided. The area sum of the first patterns 10 and the second patterns 20 is less than 1/2 of the product of the first arrangement length L1 and the second arrangement length L2, thus facilitating disposing the plurality of first patterns and the plurality of second patterns to further improve the measurement accuracy and increase the yield of a fabricated semiconductor device.

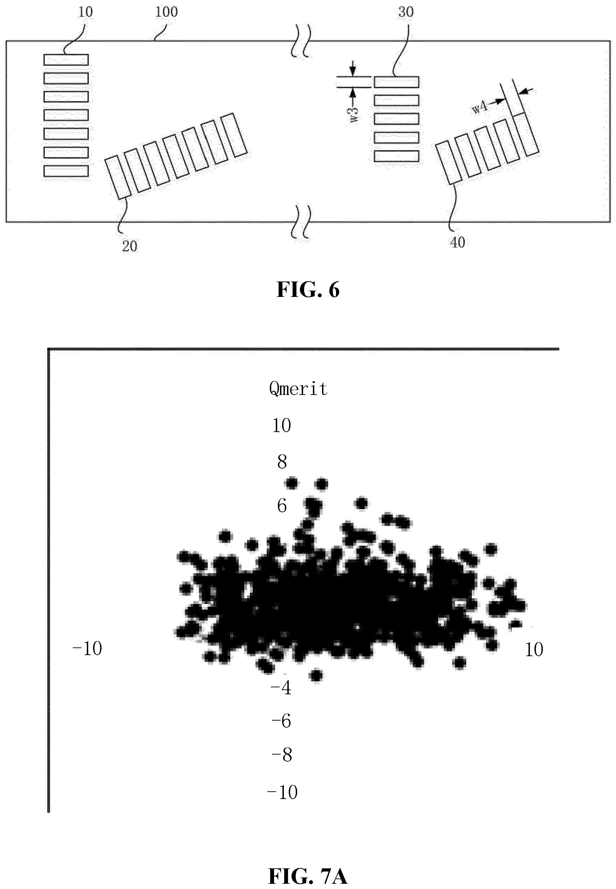

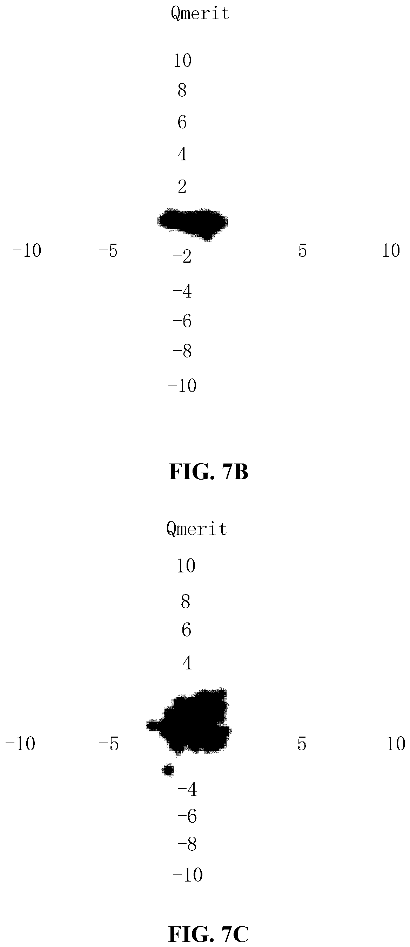

In one embodiment of the present disclosure, referring to FIG. 3, the first patterns are provided as the first rectangular through holes 11. The plurality of first rectangular through holes 11 are arranged at intervals in the first direction Ox, and each has a width w1 of 0.5 um to 1.5 um, and/or a spacing d1 between adjacent first rectangular through holes 11 is 0.5 um to 1.5 um. The size of the first rectangular through hole 11 is set to ensure, during the high-energy exposure, that the photoresist at the position of the first rectangular through hole can be exposed and developed. Meanwhile, the spacings between the first rectangular through holes 11 are set to ensure, during the high-energy exposure, that the photoresist between the first rectangular through holes 11 may not be destroyed. The formed marking graph has an excellent appearance, thus facilitating the accurate measurement of the marking graph. As shown in FIG. 7A and FIG. 7B, compared with the traditional marking graph, a Qmerit value in a measurement result obtained by using the marking graph in the present embodiment is relatively small and more convergent, indicating that the quality of the marking graph in the present embodiment is higher, and the obtained measurement result is more reliable and higher in accuracy.

In other embodiments of the present disclosure, gaps between the first patterns may be one or more of a circle, an ellipse, a triangle, or a polygon.

In one embodiment of the present disclosure, continuing to refer to FIG. 3, the second patterns are set as second rectangular photoresist graphs 22. A plurality of second rectangular photoresist graphs 22 are arranged at intervals in the second direction Oy, and have a second arrangement length L2 in the second direction Oy. The first patterns are set as first rectangular through holes 11. A plurality of first rectangular through holes 11 are arranged at intervals in the first direction Ox, and have a first arrangement length L1 in the first direction Ox. An area sum of the first rectangular through holes 11 and the second rectangular photoresist graphs 22 is less than 1/2 of the product of the first arrangement length L1 and the second arrangement length L2. A width w2 of each second rectangular photoresist graph 22 is 1.5 um to 3.5 um, and a spacing d2 between adjacent second rectangular photoresist graphs 22 is 0.5 um to 1.5 um. When the second patterns are photoresist graphs, specifically, the width of each second rectangular photoresist graph 22 is greater than the spacing between adjacent second rectangular photoresist graphs 22, so as to prevent the second rectangular photoresist graph 22 from collapsing when the photoresist layer is too thick, which facilitates realizing accurate measurement of the marking graphs. Meanwhile, by using the first patterns of the gap patterns and the second patterns of the photoresist graphs, different types of patterns can be detected in the marking graphs in the same layer or in the same marking graph in the same layer.

In one embodiment of the present disclosure, a distance from the first patterns to the second patterns is greater than a sum of the spacing between the first patterns and the spacing between the second patterns. Continuing to refer to FIG. 3, the first pattern is a first rectangular through hole 11, and the spacing d1 between adjacent first rectangular through holes 11 is 0.5 um to 1.5 um. The second pattern is a second rectangular photoresist graph 22, and the spacing d2 of the adjacent second rectangular photoresist graphs 22 is 0.5 um to 1.5 um. The distance between the first rectangular through hole 11 and the second rectangular photoresist graph 22 is greater than the sum of the spacing d1 between the adjacent first rectangular through holes 11 and the spacing d2 between the adjacent second rectangular photoresist graphs 22 to ensure that a boundary between the first rectangular through hole 11 and the second rectangular photoresist graph 22 is clear and prevent influence on a measurement result.

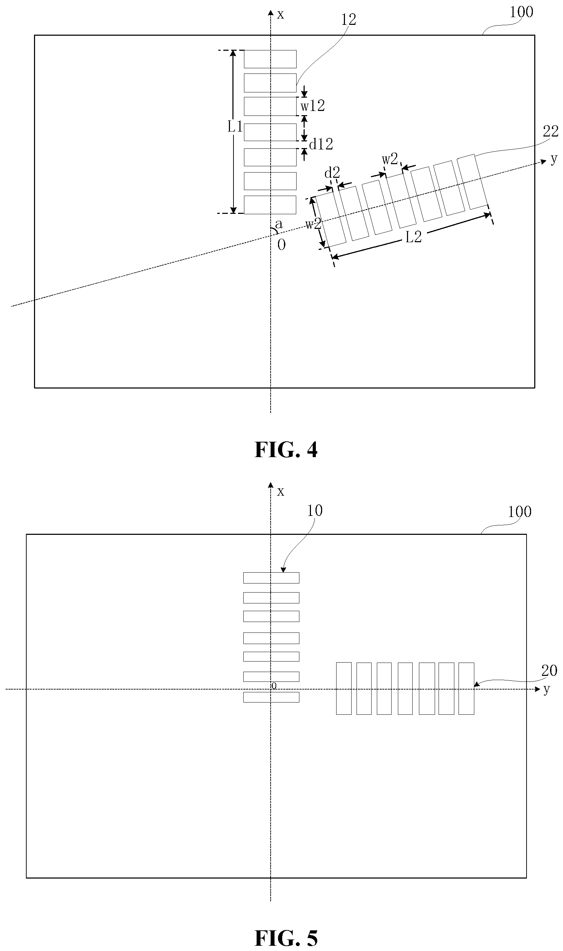

In one embodiment of the present disclosure, referring to FIG. 4, the first patterns are set as first rectangular photoresist graphs 12, and the second patterns are set as second rectangular photoresist graphs 22. The plurality of first rectangular photoresist graphs 12 are arranged at intervals in the first direction Ox, and have a width w12 of 2 um to 3 um. A spacing d12 between the first rectangular photoresist graphs 12 is 1 um to 1.5 um. The plurality of second rectangular photoresist graphs 22 are arranged at intervals in the second direction Oy, and have a width w2 of 2 um to 3 um. A spacing d2 between the second rectangular photoresist graphs 22 is 1 um to 1.5 um. When the first patterns and the second patterns of the present embodiment are the photoresist graphs, specifically, the width of the first rectangular photoresist graph 12 is greater than the spacing between the adjacent first rectangular photoresist graphs 12, and the width of the second rectangular photoresist graph 22 is greater than the spacing between the adjacent second rectangular photoresist graphs 22 to prevent the first rectangular photoresist graphs 12 or the second rectangular photoresist graphs 22 from collapsing when the photoresist layer is too thick. Especially, when the thickness of the photoresist is greater than 1.2 um, the widths and the spacings of the above-mentioned photoresist graphs are beneficial to ensure the quality of the marking graphs and realize the accurate measurement of the marking graphs. As shown in FIG. 7A and FIG. 7C, compared with the traditional marking graph, a Qmerit value in a measurement result obtained by using the marking graph in the present embodiment is relatively small and more convergent, indicating that the quality of the marking graph in the present embodiment is higher, and the obtained measurement result is more reliable and higher in accuracy. In other embodiments of the present disclosure, the photoresist graphs in the first patterns 10 and the second patterns 20 may be one or more of a circle, an ellipse, a triangle, or a polygon.

Continuing to refer to FIG. 4, the various first rectangular photoresist graphs 12 are arranged at equal intervals in the first direction Ox, and the various second rectangular photoresist graphs 22 are arranged at equal intervals in the second direction Oy, so that the complexity of preparation of the marking graphs is reduced while guaranteeing the measurement accuracy of the marking graphs.

In one embodiment of the present disclosure, referring to FIG. 5, the included angle between the first direction Ox and the second direction Oy is 90 degrees, so that detection results in an X direction and a Y direction in a right-angle coordinate system can be achieved conveniently.

In one embodiment of the present disclosure, referring to FIG. 6, first graphs 30 and second graphs 40 are also formed in the photoresist layer 100. An arrangement direction of the first graphs 30 is parallel to an arrangement direction of the first patterns 10, and an arrangement direction of the second graphs 40 is parallel to an arrangement direction of the second patterns 20. The first graphs 30 and the second graphs 40 are used to define the position and the shape of a semiconductor device structure of a chip region. The arrangement direction of the first graphs 30 is parallel to the arrangement direction of the first patterns 10, and the arrangement direction of the second graphs 40 is parallel to the arrangement direction of the second patterns 20, which can reduce the influence of photolithography conditions on the measurement results. The measurement result of the marking graphs can better reflect a real situation of the first graphs 30 and the second graphs 40 of the chip region.

Continuing to refer to FIG. 6, the first graphs 30 are graphs with gaps. The second graphs 40 are photoresist graphs. The first graphs 30 are graphs with gaps, which are consistent with the type of the first patterns 10, that is, the first patterns 10 are also graphs with gaps. The second graphs 40 are photoresist graphs, which are consistent with the type of the second patterns 20, that is, the second patterns 20 are also photoresist graphs. For example, continuing to refer to FIG. 6, the first graph 30 are provided as third rectangular through holes. An arrangement direction of the plurality of third rectangular through holes is parallel to the arrangement direction of the first patterns 10. The second graphs 40 are provided as fourth rectangular photoresist graphs, and an arrangement direction of the plurality of fourth rectangular photoresist graphs is parallel to the arrangement direction of the second patterns. It is ensured that the graphs in the chip region are consistent with the graph type of the marking graphs, so that the measurement result of the marking graphs can better reflect the real situation of the graphs in the chip region.

In one embodiment of the present disclosure, continuing to refer to FIG. 6, a width w3 of each of the first graphs 30 is 0.5 um to 1.5 um. A width w4 of each of the second graphs 40 is 1.5 um to 3.5 um, to ensure the quality of the first graphs 30 and the quality of the second graphs 40, so that the position and shape of the semiconductor device structure in the chip region can be defined accurately.

It should be noted that the above-mentioned embodiments are only for illustrative purposes and are not meant to limit the disclosure.

All the embodiments in the present specification are described in a progressive manner. Contents mainly described in each embodiment are different from those described in other embodiments. Same or similar parts of all the embodiments refer to each other.

Various technical features in the foregoing embodiments may be randomly combined. For ease of simple description, not all possible combinations of various technical features in the foregoing embodiments are described. However, as long as the combinations of these technical features do not contradict, they should be regarded as falling within the scope of the present specification.

The foregoing embodiments represent only a few implementation modes of the present disclosure, and the descriptions are specific and detailed, but should not be construed as limiting the patent scope of the present disclosure. It should be noted that those of ordinary skill in the art may further make variations and improvements without departing from the conception of the present disclosure, and these variations and improvements all fall within the protection scope of the present disclosure. Therefore, the patent protection scope of the present disclosure should be subject to the appended claims.

## Claims

1. A semiconductor structure, comprising:
several first patterns arranged in a first direction and located in a photoresist layer with a thickness greater than 1.2 um, and several second patterns arranged in a second direction, wherein the first direction and the second direction have an included angle;
wherein the first patterns have a first arrangement length in the first direction; the second patterns have a second arrangement length in the second direction; and an area sum of the first patterns and the second patterns is less than 1/2 of a product of the first arrangement length and the second arrangement length.

2. The semiconductor structure of claim 1, wherein the first patterns and the second patterns are patterns with gaps.

3. The semiconductor structure of claim 1, wherein the first patterns are patterns with gaps, and
wherein at least one of the following applies:
each of the first patterns has a width of 0.5 um to 1.5 um, or
a spacing between two adjacent ones of the first patterns is 0.5 um to 1.5 um.

4. The semiconductor structure of claim 3, wherein the second patterns are photoresist patterns and
wherein at least one of the following applies:
each having a width of 1.5 um to 3.5 um, or
a spacing between two adjacent ones of the second patterns is 0.5 um to 1.5 um.

5. The semiconductor structure of claim 1, wherein the first patterns and the second patterns are photoresist patterns, each having a width of 2 um to 3 um; a spacing between two adjacent ones of the first patterns is 1 um to 1.5 um; and a spacing between two adjacent ones of the second patterns is 1 um to 1.5 um.

6. The semiconductor structure of claim 1, wherein the first patterns are arranged at equal intervals in a first direction, and the second patterns are arranged at equal intervals in a second direction.

7. The semiconductor structure of claim 1, wherein an included angle between the first direction and the second direction is 90 degrees.

8. The semiconductor structure of claim 4, wherein several first graphs and several second graphs are further formed in the photoresist layer; an arrangement direction of the first graphs is parallel to the first direction; and an arrangement of the second graphs is parallel to the second direction.

9. The semiconductor structure of claim 8, wherein the first graphs are graphs with gaps, and the second graphs are photoresist graphs.

10. The semiconductor structure of claim 9, wherein a width of each of the first graphs is 0.5 um to 1.5 um, and a width of each of the second graphs is 1.5 um to 3.5 um.

11. The semiconductor structure of claim 4, wherein a distance from the first patterns to the second patterns is greater than a sum of the spacing between the first patterns and the spacing between the second patterns.
